Europäisches Patentamt

European Patent Office

Office européen des brevets

(11) Veröffentlichungsnummer: **0 450 274 A1**

## (12) EUROPÄISCHE PATENTANMELDUNG

(21) Anmeldenummer: 91101433.0

(22) Anmeldetag: 04.02.91

(51) Int. Cl.5: **H01L 29/808**, H01L 29/80, H01L 21/337, H01L 29/207, H01L 21/205

Die Bezeichnung der Erfindung wurde geändert (Richtlinien für die Prüfung im EPA, A-III, 7.3).

(30) Priorität: 07.02.90 DE 4003644
09.08.90 DE 4025269

(43) Veröffentlichungstag der Anmeldung:
09.10.91 Patentblatt 91/41

(84) Benannte Vertragsstaaten:
BE CH DE FR GB IT LI NL SE

(71) Anmelder: **Forschungszentrum Jülich GmbH
Postfach 1913, Wilhelm-Johnen-Strasse
W-5170 Jülich(DE)**

(72) Erfinder: **Lüth, Hans Prof. Dr.
Eupener Strasse 299b
W-5100 Aachen(DE)**

(54) **Halbleiteranordnung mit durch Feldeffekt steuerbarer Raumladungszone und Verfahren zu deren Herstellung.**

(57) Die Erfindung betrifft ein elektronisches Bauelement, insbesondere ein Permeable Base Transistor, das mehrere im Verbund hergestellte Schichten und wenigstens eine steuerbare Raumladungszone aufweist. Ziel ist ein elektronisches Bauelement, bei dessen Herstellung keine heteroepitaktische Abschaltung metallischer Komponenten erforderlich ist, sondern lediglich homoepitaktische Prozesse Anwendung finden. Erfindungsgemäß wird dieses Ziel durch ein elektronisches Bauelement erreicht, bei dem als eine steuerbare Raumladungszone ein pn-Übergang mit einer p-leitenden und einer n-leitenden Schicht vorgesehen ist. Die p-leitende Schicht besteht dabei beispielsweise aus kohlenstoffdotiertem GaAS und die n-leitende Schicht aus GaAs. Die Erfindung bezieht sich ferner auf ein Verfahren zur Herstellung eines solchen elektronischen Bauelementes.

FIG. 6

EP 0 450 274 A1

## ELEKTRONISCHES BAUELEMENT UND VERFAHREN ZU DESSEN HERSTELLUNG

Die Erfindung bezieht sich auf ein elektronisches Bauelement, insbesondere einen Permeable Base Transistor (PBT), mit mehreren im Verbund hergestellten Schichten und mit wenigstens einer steuerbaren Raumladungszone. Die Erfindung bezieht sich ferner auf ein Verfahren zur Herstellung eines solchen elektronishen Bauelementes.

Für die Verwendung in Supercomputern und schnellen Datennetzen im Rahmen der Informationstechnik sind integrierte Schaltungen als schnelle Mikrowellenbauelemente in der Entwicklung. Von hoher Bedeutung sind dabei integrierte Schaltungen auf GaAs Chips, die auf dem Materialsystem GaAs/AlGaAs basieren. Bauelemente, die in diesem Rahmen bisher benutzt werden, sind der MESFET und der HEMT, beides Feldeffekttransistoren, bei denen der Stromtransport parallel zur Oberfläche des Chips stattfindet. Eine wesentliche geschwindigkeitsbestimmende Größe, die Laufzeit unter dem Gate, ist hierbei durch die Dimension der lithographisch erzielten lateralen Strukturierung des Gates ($> 0,2 \mu$m) gegeben.

Bei dem schon 1979 vorgeschlagenen Permeable Base Transistor handelt es sich im Prinzip um einen Feldeffekttransistor, jedoch mit Stromrichtung senkrecht zur Chip-Oberfläche, bei dem die "Laufzeit unter dem Gate", d.h. die Gate-Länge durch die vertikale Strukturierung, d.h. die Dicke der epitaktisch abzuscheidenden Basis-Schicht vorgegeben wird. Dies kann, sofern moderne Epitaxiemethoden wie Molekularstrahl-Epitaxie (MBE), Metallorganische Gasphasen Epitaxie (MOCVD) oder Metallorganische Molekularstrahl Epitaxie (MOMBE, CBE, GFMBE) zur Herstellung der metallischen, strukturierten Basis herangezogen werden können, bis auf Schichtdicken von einigen Atomlagen hinab kontrolliert durchgeführt werden.

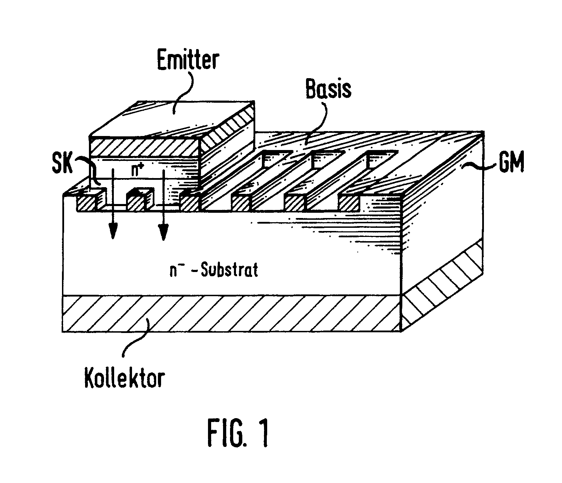

Eine schematische Darstellung des bekannten Permeable Base Transistors ist in Figur 1 gegeben. Die lateral fingerartig strukturierte metallische Basis B läßt Stromkanäle SK offen, in denen wegen der am Metall-Halbleiter-Übergang auftretenden Schottky-Barriere eine Verarmungszone existiert, deren räumliche Ausdehnung durch die Vorspannung an der metallischen Basis geändert werden kann. Bei einer typischen Ausdehnung der Raumladungszone von ~ 1000 Å im spannungsfreien Zustand kann man bei einer Öffnungsweite der Basis von 2000 bis 5000 Å durch geeignete Vorspannungen an der Basis den Strom durch die Basis steuern. Bisherige Realisierungsmöglichkeiten für diesen Transistortyp sind bei Silicium als Grundmaterial GM die Herstellung der Basis aus metallischen, epitaktisch aufwachsenden Ni- oder Co-Siliciden (NiSi$_2$, CoSi$_2$). Im Falle von GaAs als Grundmaterial wurden polykristallin abgeschiedene Metallstrukturen epitaktisch wiederum von der Seite her mit GaAs überwachsen. Des weiteren werden z.Zt. quasimetallische, epitaktisch aufwachsende Er-Arsenid Schichtstrukturen als Basismaterial diskutiert. Durchschlagende Erfolge bei der Herstellung, zumindest im GaAs-System sind bisher nicht bekannt.

Aufgabe der Erfindung ist ein elektronisches Bauelement der eingangs bezeichneten Art, bei dessen Herstellung keine heteroepitaktische Abscheidung metallischer Komponenten wie Siliciden, ErAs usw. und deren fehlerfreies Überwachsen erforderlich ist, sondern lediglich homoepitaktische Prozesse Anwendung finden. Aufgabe ist ferner ein entsprechendes Verfahren zur Herstellung eines solchen Bauelementes.

Diese Aufgabe wird durch ein elektronisches Bauelement gelöst, bei dem als eine steuerbare Raumladungszone ein pn-Übergang mit einer p-leitenden und einer n-leitenden Schicht vorgesehen ist.

Bei einem auf GaAs-integriertem Bauelement besteht die p-leitende Schicht aus kohlenstoffdotiertem GaAs, während die n-leitende Schicht auch aus GaAs besteht. Die Dotierung wird beispielsweise mittels Si, SiH$_4$, Si$_2$H$_6$, S oder H$_2$S durchgeführt.

Im Unterschied zum oben erwähnten, bekannten Permeable Base Transistor, wo die in ihrer räumlichen Ausdehnung steuerbare Raumladungszone durch den Metall-Halbleiterkontakt als Schottky-Barriere aufgebaut wird, handelt es sich bei dem erfindungsgemäßen p$^+$n-Permeable Base Transistor um die Raumladungszone eines p$^+$n-Überganges, der sich je nach n-Dotierung des GaAs-Grundmaterials ($10^{17}$ -$10^{18}$ cm$^{-3}$) etwa 500 - 1000 Å in die Schicht, d.h. in den stromtragenden Bereich hinein ausdehnt. Auf der anderen Seite, d.h. in der quasimetallischen p$^+$-Basis ist die Ausdehnung entsprechend dem hohen Dotierungsgrad unterhalb von 50 Å.

Wegen der starken p$^+$-Dotierung liegt quasimetallisches Leitfähigkeitsverhalten der Basis vor. Raumladungskapazitäten im Bereich des Basis p$^+$n-Überganges sind vergleichbar mit denen in entsprechenden Schottky-Barrieren normaler Permeable Base-Transistoren (geringe Ausdehnung der p$^+$ Raumladungszone).

Die der Erfindung zugrundeliegende Aufgabe wird ferner durch ein Verfahren zur Herstellung des erfindungsgemäßen Bauelementes gelöst, bei dem zur Bildung wenigstens einer Raumladungszone eine p-leitende Schicht mit einer n-leitenden Schicht zu einem pn-Übergang miteinander verbunden werden.

Das erfindungsgemäße Verfahren besticht durch seine Einfachheit, da der neuartige Permeable Base Transistor aus ein und demselben Material nur durch Dotierung der Basis herstellbar ist.

Zur Herstellung eines auf GaAs integrierten Bauelementes wird als Grundmaterial zur Herstellung der pleitenden Schicht GaAs gewählt, wobei zur p-(Löcher)Dotierung zweckmäßigerweise Kohlenstoff in das GaAs eingebaut wird.

Die p-Dotierung durch Kohlenstoffeinbau kann in an sich bekannter Weise bei der MOMBE-Abscheidung von GaAs mittels Trimethylgallium (TMG) geschehen, wobei p-Dotierungen bis in den Bereich von $10^{21}$ x $cm^{-3}$ erzielt werden können. Durch Wahl der Wachstumsparameter kann so eine quasimetallische, p-leitende Schicht von GaAs erzeugt werden, deren Dicke im MOMBE-Prozeß gezielt bis hinab auf atomare Dimensionen (wenige Å) kontrolliert abgeschieden werden kann.

Als Grundmaterial zur Herstellung der n-leitenden Schicht wird ebenfalls zweckmäßigerweise GaAs gewählt, worauf zur n-Dotierung des GaAs elementares Si, $SiH_4$, $Si_2H_6$, S oder $H_2S$ eingesetzt werden. Triäthylgallium (TEG) führt in bekannter Weise als Quellmaterial bei der Epitaxie zu sehr reinem GaAs, das gezielt während der Epitaxie durch den Einsatz der genannten Stoffe n-dotiert werden kann.

Die Anwendung des erfindungsgemäßen Verfahrens führt, ausgehend vom Grundmaterial GaAs, zum erfindungsgemäßen Bauelement, dessen permeable Basis nicht aus einer metallischen Komponente besteht, die vielmehr hoch-p-leitenden (Löcher)-Leitungscharakter hat. Die hohe $p^+$-Leitung (p ~ $10^{21}$ x $cm^{-3}$) wird dabei durch Kohlenstoffakzeptoren erzeugt.

In der Zeichnung ist in Figur 1 ein Permeable Base Transistor bekannter Art und in den weiteren Figuren das Verfahren gemäß der Erfindung zur Herstellung eines Permeable Base Transistors gemäß der Erfindung in einzelnen Verfahrensschritten anhand der diesen Verfahrensschritten entsprechend gefertigten Teilen des Bauelementes schematisch dargestellt.

Es zeigen

Figur 1 die bekannte Version des Permeable Base Transistors,

Figur 2 einen GaAs(100)-Wafer als Ausgangsmaterial des Bauelementes mit erster n-dotierter Schicht,

Figur 3 mit p-dotierter Schicht,

Figur 4 nach Strukturierung der obersten Schicht mittels in

Figur 4a in Aufsicht dargestellter Fingermaske,

Figur 5 nach weiterem Überwachsen mit n-dotierter Schicht und

Figur 6 das fertige Bauelement, nach Abscheidung einer weiteren $n^+$-dotierten Schicht (Kontakt) und Metallisierung (Bilden des Emitters) und Freilegen der Basis.

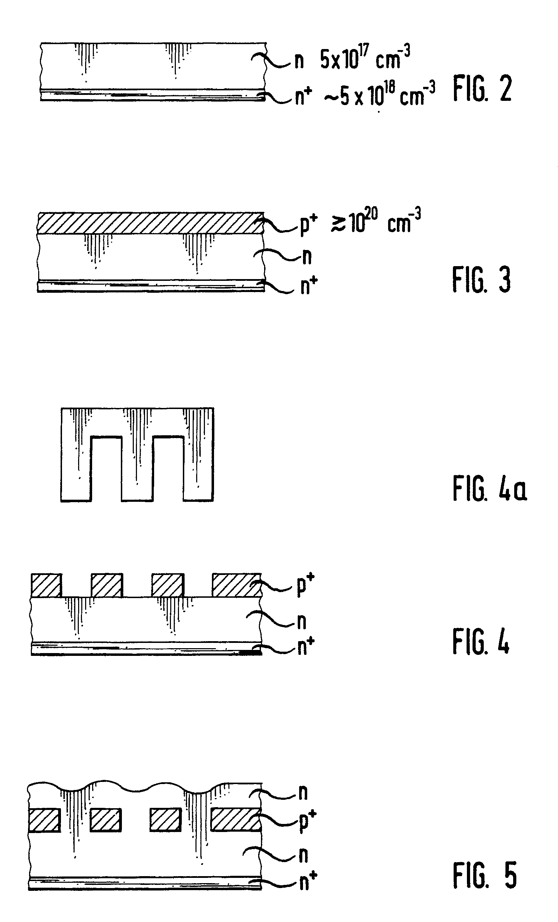

In Figur 2 ist ein GaAs(100)-Wafer dargestellt, der als Ausgangsmaterial für die Herstellung des Bauelementes dient. Die obere > 1000 Å dicke Schicht wurde mittels MOMBE-Abscheidung unter Anwendung von TEG und n-Dotierung erzeugt. Sie ist als Kollektorgebiet vorgesehen und weist eine n-Dotierung im Bereich n = 5 x $5^{17}$ x $10^{-3}$ auf. Auch MOCVD kann für diesen Prozeß eingesetzt werden.

Die Darstellung in Figur 3 zeigt eine weitere, mittels TMG nach dem MOMBE-Verfahren abgeschiedene GaAs-Schicht, deren Dicke 1000 - 10000 Å beträgt. Bei genügend hohem III/V-Verhältnis führt diese Verfahrensweise zu einer extrem hohen $p^+$-Dotierung dieser Schicht im Bereich > $10^{20}$ x $cm^{-3}$. Auch dieser Prozeß kann mittels MOCVD unter Hinzufügen von Kohlenwasserstoffen zu geeignet hoher p-Dotierung führen.

Aus den Figuren 4 und 4a ist der nächste Verfahrensschritt zu entnehmen. Er besteht darin, daß das Wachstum der GaAs abgebrochen und eine externe lithographische Strukturierung dieser $p^+$-Schicht mittels der in Figur 4a dargestellten Fingermaske vorgenommen werden. Die $p^+$-Basisfingerstruktur wird sodann, wie aus Figur 5 hervorgeht, mit n und GaAs unter Verwendung von TEG und Dotierungsquelle (Dotierung ~ 5 x $10^{17}$ x $cm^{-3}$ weiter überwachsen.

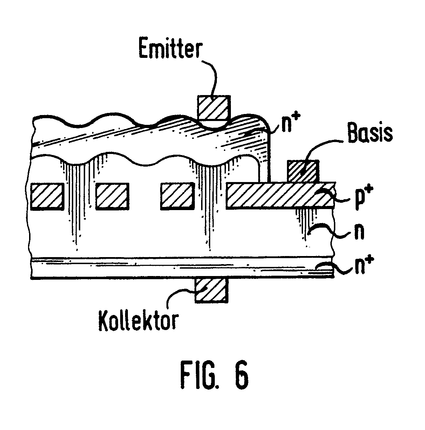

Die gemäß Figur 5 gebildete n-Schicht wird, evtl. nach vorheriger Epitaxie einer $n^+$-Schicht geringer Dicke und einer Dotierung dieser Schicht im Bereich von n ≧ $10^{19}$ x $cm^{-3}$, mit einer Kontaktzone als Emitter versehen (siehe Figur 6).

Figur 6 zeigt ferner das Kontaktieren der Basis nach entsprechendem Ätzen auf Basistiefe.

## Patentansprüche

1. Elektronisches Bauelement, insbesondere ein Permeable Base Transistor (PBT), mit mehreren im Verbund hergestellten Schichten und mit wenigstens einer steuerbaren Raumladungszone,
**dadurch gekennzeichnet,**
daß als eine solche Raumladungszone ein pn-Übergang mit einer p-leitenden und einer n-leitenden Schicht vorgesehen ist.

2. Elektronisches Bauelement nach Anspruch 1,
**dadurch gekennzeichnet,**
daß die p-leitende Schicht aus kohlenstoffdotiertem GaAs besteht.

3. Elektronisches Bauelement nach Anspruch 1 oder 2,
**dadurch gekennzeichnet,**
daß die n-leitende Schicht aus GaAs besteht.

4. Verfahren zur Herstellung eines elektronischen Bauelements mit mehreren unter Verwendung von Epitaxie-Verfahren im Verbund hergestellten Schichten und mit wenigstens einer Raumladungszone,
**dadurch gekennzeichnet,**
daß zur Bildung der Raumladungszone eine p-leitende Schicht mit einer n-leitenden Schicht zu einem pn-Übergang miteinander verbunden werden.

5. Verfahren nach Anspruch 4,
**dadurch gekennzeichnet,**
daß als Grundmaterial zur Herstellung der p-leitenden Schicht GaAs gewählt wird.

6. Verfahren nach Anspruch 5,
**dadurch gekennzeichnet,**
daß zur Dotierung der p-leitenden Schicht Kohlenstoff gewählt wird.

7. Verfahren nach einem der Ansprüche 4 bis 6,
**dadurch gekennzeichnet,**
daß als Grundmaterial zur Herstellung der n-leitenden Schicht GaAs gewählt wird.

8. Verfahren nach Anspruch 7,
**dadurch gekennzeichnet,**
daß zur Dotierung der n-leitenden Schicht ein Material aus der Gruppe elementares Si, $SiH_4$, $Si_2H_6$, S, $H_2S$ gewählt wird.

**FIG. 1**

$n \quad 5 \times 10^{17} \, cm^{-3}$

$n^+ \quad \sim 5 \times 10^{18} \, cm^{-3}$ FIG. 2

$p^+ \quad \gtrsim 10^{20} \, cm^{-3}$

$n$

$n^+$ FIG. 3

FIG. 4a

$p^+$

$n$

$n^+$ FIG. 4

$n$

$p^+$

$n$

$n^+$ FIG. 5

FIG. 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | SOVIET TECHNICAL PHYSICS LETTERS, Band 12, Nr. 2, Februar 1986, Seiten 77-78; ZH.I. ALFEROV et al.: "Buried-gate gallium arsenide vertical field-effect transistor" * Das ganze Dokument * | 1,3 | H 01 L 29/808 H 01 L 29/80 H 01 L 21/337 H 01 L 29/207 H 01 L 21/205 |
| Y | IDEM | 2,4-8 | |
| Y | APPLIED PHYSICS LETTERS, Band 54, Nr. 1, 2. Januar 1989, Seiten 39-41; T. MAKIMOTO et al.: "AlGaAs/GaAs heterojunction bipolar transistors with heavily C-doped base layers grown by flow-rate modulation epitaxy" * Das ganze Dokument * | 2,4-8 | |
| X | INTERNATIONAL ELECTRON DEVICES MEETING, TECHNICAL DIGEST, Washington, DC, 3.-5. Dezember 1979, Seiten 84-87, IEEE, New York, US; T. OHMI: "Power static induction transistor technology" * Abschnitt: "Conventional SIT"; Figur 1(a) * | 1 | |

|  |  |
|---|---|
| | **RECHERCHIERTE SACHGEBIETE (Int. Cl.5)** |
| | H 01 L |

Der vorliegende Recherchenbericht wurde für alle Patentansprüche erstellt

| Recherchenort | Abschlußdatum der Recherche | Prüfer |
|---|---|---|
| Den Haag | 21 März 91 | MORVAN D.L.D. |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument
─────────────────
& : Mitglied der gleichen Patentfamilie, übereinstimmendes Dokument